Europäisches Patentamt

European Patent Office

Office européen des brevets

(11) Publication number: **0 091 256**
**B1**

# EUROPEAN PATENT SPECIFICATION

(45) Date of publication of patent specification: **09.08.89**

(51) Int. Cl.⁴: **H 01 L 27/08**

(21) Application number: **83301735.3**

(22) Date of filing: **28.03.83**

(54) CMOS device.

(30) Priority: **31.03.82 JP 53072/82**

(43) Date of publication of application:
**12.10.83 Bulletin 83/41**

(45) Publication of the grant of the patent:
**09.08.89 Bulletin 89/32**

(84) Designated Contracting States:
**DE FR GB**

(73) Proprietor: **FUJITSU LIMITED**
**1015, Kamikodanaka Nakahara-ku**
**Kawasaki-shi Kanagawa 211 (JP)**

(72) Inventor: **Inaba, Touru**
**539-50, Kamikashio Totsuki-ku**
**Yokohama-shi Kanagawa 244 (JP)**

(74) Representative: **Fane, Christopher Robin King**
**et al**
**HASELTINE LAKE & CO. Hazlitt House 28**
**Southampton Buildings Chancery Lane**
**London, WC2A 1AT (GB)**

(56) References cited:

**SOLID STATE DEVICES 1980 - Conference
Series Number 57, The Institute of Physics,
Bristol and London, GB, 1981, Nine invited
papers presented at the 10th European Solid
State Device Research Conference (ESSDERC)
and the 5th Symposium on Solid State Device
Technology held at the University of York,
15-18 September 1980, pages 85-139, The
Institute of Physics; B. HOEFFLINGER et al.:
"New CMOS technologies"**

(56) References cited:
**PATENTS ABSTRACTS OF JAPAN, vol. 4, no.
44 (E-5)526r, April 5, 1980 & JP-A-55 13967
ELECTRONICS INTERNATIONAL, vol. 54, no.
20, October 1981, pages 103-105, New York,
US; J.G. POSA: "C-MOS inspires the best chips
yet for computer consumer, and
communication applications"**

Courier Press, Leamington Spa, England.

## Description

The present invention relates to a semiconductor device, more particularly to a complementary metal oxide semiconductor (CMOS) integrated circuit (IC) having a p-type island and an n-type island.

In addition to its inherent advantage of low power consumption operation, a CMOS IC offers the advantage of high speed operation. It is therefore attracting attention of a semiconductor device suited for large-scale integration and for reducing element sizes.

However, the CMOS IC has a problem with its operation characteristics namely a low, withstand voltage. In an n-channel MOS field-effect transistor (FET) according to the prior art, which, together with a p-channel MOS FET constitutes a CMOS IC, the operation voltage is limited to the following five factors:

1. The punch-through effect between the source and the drain by the electric field between the source and the drain.

2. The breakdown of the gate insulation film by the electric field between the gate and the drain.

3. The junction breakdown of the drain in the vicinity of gate by the electric field between the gate and the drain.

4. The junction breakdown in the diffusion layer by the electric field between the source and drain diffusion layers and the substrate.

5. The threshold voltage in the field region.

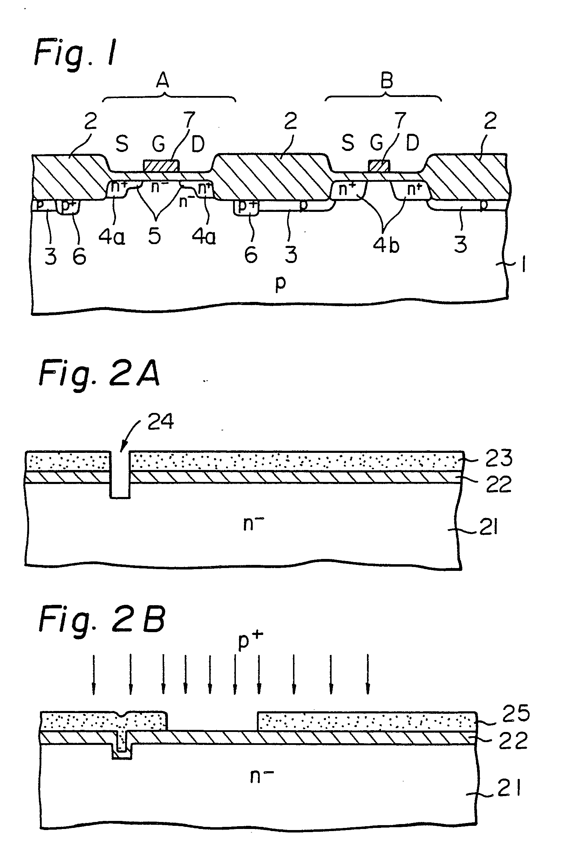

Countermeasures for the above-mentioned five factors that have been prepared in the prior art will be explained with reference to Fig. 1, which is a schematic cross-sectional view showing two forms of n-channel MOS field-effect transistor (FET) according to the prior art. Two n-channel MOS FET's, indicated by A and B, are formed on a p-type silicon substrate 1. In the silicon substrate 1, p-type channel stop diffusion layers 3, $n^+$ type diffusion layers 4a and 4b, n type diffusion layers 5, and $p^+$ type diffusion layers 6 are formed. Reference numeral 2 is a silicon dioxide film, on which polycrystalline silicon gates 7 are formed.

Now, referring to the MOS FET indicated by A in Fig. 1, to prevent the punch-through effect caused between the source and drain region, $n^+$ type diffusion layers 4a, which act as source and drain layers, are formed remote from the gate. Further, the $n^+$-type high resistance diffusion layer 5 is formed between the gate region 7 and the $n^+$-type diffusion layer 4a.

To improve the withstand voltage against breakdowns at the gate insulation film and junction breakdowns of the drain, the depletion region of the $n^-$-type diffusion layer 5 is expanded so as to decrease the electric field relative to the gate electrode.

To improve the withstand voltage against junction breakdowns of the diffusion layer, the silicon substrate 1 is used as it is, without forming a channal stop diffusion region.

To improve the threshold voltage of the field region, the $p^+$ diffusion layer 6 is formed with a high impurity concentration.

With a MOS FET which does not require such a high withstand voltage, the channel stop diffusion region may be connected to the $n^+$-type diffusion layers 4b, as indicated by B, to enhance the degree of integration.

The above-mentioned methods of increasing the withstand voltage, however, cannot be easily applied to MOS FET's formed on conventional CMOS IC's since the limit of the operation voltage is low, i.e., the limit of the operation voltage mentioned in 4 above is low, e.g., 20 odd volts with an n-channel MOS FET formed in a p-well.

CMOS IC's, furthermore, are subject to the following two additional factors.

6. The punch-through effect between the source and drain and the silicon substrate by the electric filed between the source and drain and the silicon substrate of the MOS FET in the well region.

7. Latching up.

The limit on the operation voltage of 4 varies depending upon the impurity concentration in the vicinity of source and drain diffusion layers, i.e., the withstand voltage increases with a decrease in the impurity concentration in the vicinity of the source and drain diffusion layers. With regard to 6 and 7, however, the withstand voltage generally decreases with a decrease of the impurity concentration. To increase the integration density, it is often required to form transistors in the ergions of high impurity concentrations.

It is an object of the present invention to provide a semiconductor device in which a MOS FET is formed with CMOS transistors, the MOS FET having a withstand voltage high enough in regard to junction breakdown between the source and the drain.

According to the present invention, there is provided a semiconductor device comprising a semiconductor body having a first conductivity type, a first impurity region being formed in said semiconductor body and having said first conductivity type, said first impurity region having a higher impurity concentration than said semiconductor body; a first MOS transistor of a first channel type formed in said first impurity region; a second impurity region being formed in said semiconductor body and having a second conductivity type opposite to said first conductivity type; and a second MOS transistor of a second channel type formed in said second impurity region, characterised in that a third transistor is formed in said semiconductor body having a lower impurity concentration than said first impurity region, said third transistor being a first channel type MOS transistor, formed outside the first and the seocnd impurity regions and having second conductivity type source and drain region and having a higher withstand voltage than said first MOS transistor, a CMOS circuit being formed by said first MOS transistor and said second MOS transistor.

It is preferable that the first and third transistors and p channel MOS transistor and the second transistor is n channel MOS transistor.

Further advantages and details of the present invention will now be explained with reference to the accompanying drawings; in which:

Fig. 1 is a schematic cross-sectional view of an n-channel MOS FET according to the prior art;

Figs. 2A to 2D are sectional views of major portions of a CMOS IC in manufacturing steps according to an embodiment of the present invention;

Figs. 3A to 3D are sectional views of major portions of a CMOS IC in manufacturing steps according to another embodiment of the present invention; and

Fig. 4 is a sectional view of major portions of a CMOS IC according to the present invention.

Figures 2A to 2D illustrate steps of manufacturing a MOS FET in a region of low impurity concentration on the surface of a silicon substrate. In Figs. 2A to 2D and the subsequent drawings, the same portions are denoted by the same reference numerals.

Referring to Fig. 2A, a silicon dioxide ($SiO_2$) film 22 is first formed on the surface of an n-type silicon substrate 21 by the thermal oxidation method. Then, a resist film 23 for patterning marks 24 of a mask for ion injection is formed. The positioning marks 24, which have a criss-cross shape viewed from above, are next formed by etching.

Referring to Fig. 2B, the resist film 23 is removed and the silicon dioxide film 22 is grown again by the thermal oxidation method. Another resist film 25 is formed and an n-type well region is patterned. Phosphorus ions ($P^+$) are injected by the ion implantation method under an acceleration energy of 20 to 200 KeV and a dosage of $2\times10^{12}$ to $2\times10^{14}cm^{-2}$.

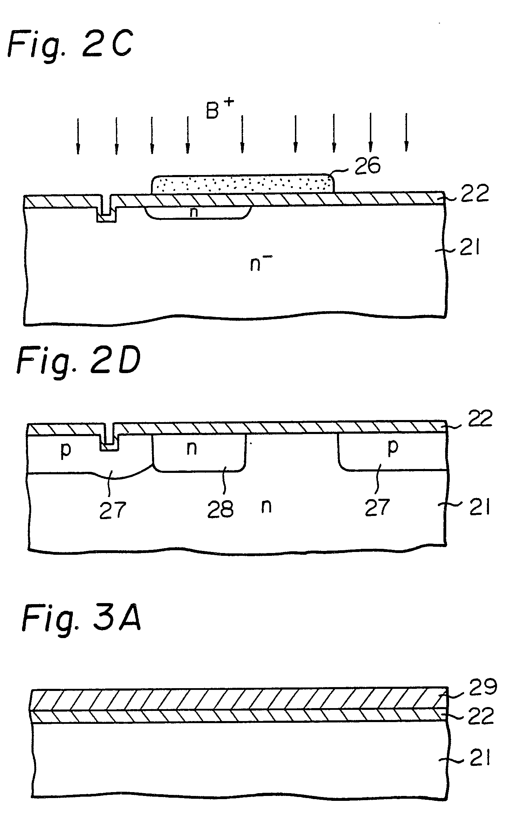

Referring to Fig. 2C, a resist film 26 is formed and patterning is effected to form a p-type well region. Boron ions ($B^+$) are then implanted by the ion implantation method. The boron ions are implanted under an acceleration energy of 20 to 200 KeV and a dosage of $2\times10^{12}$ to $2\times10^{14}cm^{-2}$.

Referring to Fig. 2D, impurity diffusion layers 27 and 28 are next formed by heat treatment at about 1200°C.

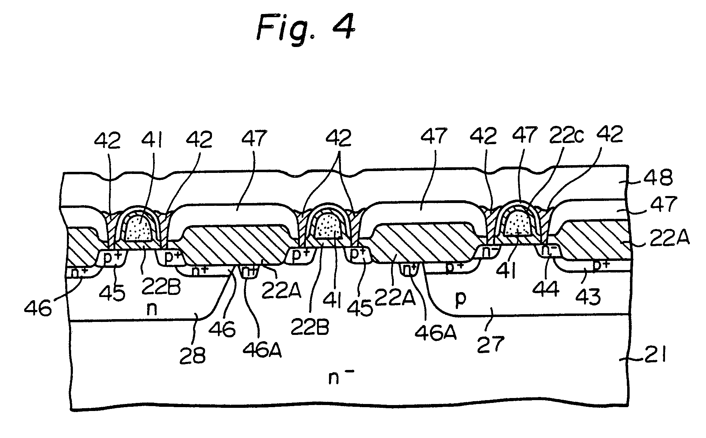

Then, as in the case of producing conventional CMOS IC's, channel stop diffusion layers 43, 46 and 46A are formed by the ion implantation method, as shown in Fig. 4, an oxide film 22A is formed on the field regions, and a gate oxide film 22B is formed after an oxide film 22 has been removed. Polycrystalline silicon gates 41, an oxide film 22C, phosphosilicate glass (PSG) film 47, and aluminum electrodes 42 are formed. Finally, the device is covered with a PSG film 48 to complete the CMOS IC.

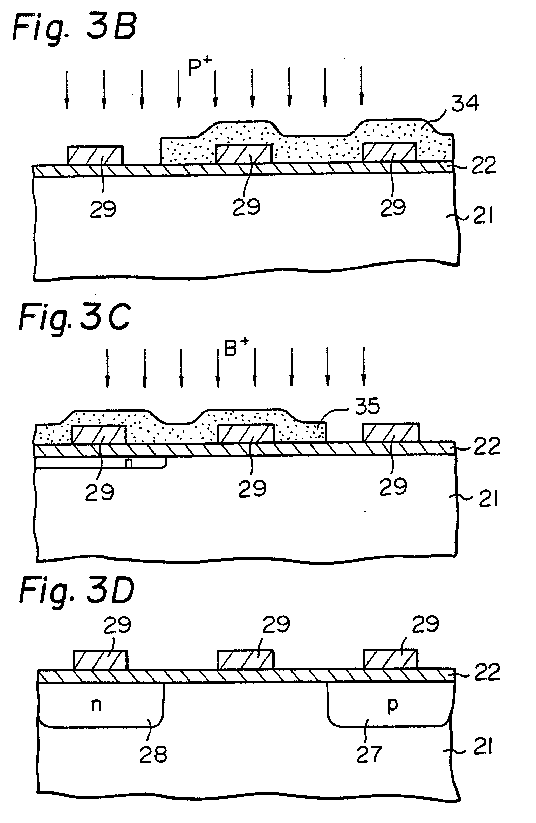

Referring to Fig. 3A, a silicon dioxide film 22 is formed by the thermal oxidation on the surface of an n-type silicon substrate 21. A nitride film 29 is formed to a thickness of about 1,000 nm. Then, as in Fig. 3B, the nitride film 29 is patterned to form active regions, a pattern for forming an n-type well region is formed by a resist film 34, and phosphorus ions are implanted by the ion implantation method under an acceleration energy of 100 to 300 KeV and a dosage of $2\times10^{12}$ to $2\times10^{14}cm^{-2}$.

Similarly, as shown in Fig. 3C, a pattern 35 for forming a p-type well region is formed. Boron ions are implanted by the ion implantation method under an acceleration energy of 50 to 200 KeV and a dosage of $2\times10^{12}$ to $2\times10^{14}cm^{-2}$.

Then, as shown in Fig. 3D, impurity diffusion layers 27 and 28 are formed by heat treatment. Therefore, the MOS FET is formed in the same manner as in the case of producing conventional CMOS IC's, thereby completing the CMOS IC illustrated in Fig. 4.

Referring to Fig. 4, which is a sectional view of major portions of a CMOS IC produced according to the above-mentioned embodiments of the present invention, a central MOS FET among three MOS FET's is formed on portion of the silicon substrate 21 where no well region is formed and where the impurity concentration is low. Further, in the central MOS FET the channel stop 46A does not touch the source-drain regions. Compared with the two other transistors, furthermore, the central transistor can have an increased gate width, although the drawing illustrates the same width. The gate width can in practice be increased from the conventional width of 2 to 3 μm (microns) to as great as about 6 μm. Accordingly, the central transistor exhibits improved characteristics against the punch-through effect. The central MOS FET of Fig. 4 may be in the form of a high withstand voltage MOS FET as shown at A in Fig. 1.

## Claims

1. A semiconductor device comprising a semiconductor body (21) having a first conductivity type, a first impurity region (28) being formed in said semiconductor body and having said first conductivity type, said first impurity region having a higher impurity concentration than said semiconductor body; a first MOS transistor of a first channel type formed in said first impurity region; a second impurity region (27) being formed in said semiconductor body and having a second conductivity type opposite to said first conductivity type; and a second MOS transistor of a second channel type formed in said second impurity region, characterized in that a third transistor is formed in said semiconductor body having a lower impurity concentration than said first impurity region, said third transistor being a first channel type MOS transistor, formed outside the first and the second impurity regions and having second conductivity type source and drain regions (45), and having a higher withstand voltage than said first transistor, a CMOS circuit being formed by said first transistor and said second transistor.

2. A semiconductor device according to claim 1, characterized in that said first and third transistors are p channel MOS transistors and said second transistor is an n channel MOS transistor.

3. A semiconductor device according to claim 1 or claim 2, characterised in that said third transistor is located between said first and second transistors.

4. A semiconductor device according to any preceding claim, characterised in that said third transistor has a greater gate width than said first and second transistors.

**Patentansprüche**

1. Halbleitervorrichtung mit einem Halbleiterkorper (21), von einem ersten Leitfähigkeitstyp, mit einem ersten Verunreinigungsbereich (28), der in dem genannten Halbleiterkörper gebildet ist und denselben ersten Leitfähigkeitstyp hat, welcher genannte erste Verunreinigungsbereich eine höhere Verunreinigungskonzentration als der genannte Halbleiterkörper hat; einem ersaten MOS-Transistor von einem ersten Kanaltyp, der in dem genannten ersten Verunreinigungsbereich gebildet ist; einem zweiten Verunreinigungsbereich (27), der in dem genannten Halbleiterkörper gebildet ist und einen zweiten Leitfähigkeitstyp hat, der zu den genannten ersten Leitfähigkeitstyp entgegengesetzt ist, und einem zweiten MOS-Transistor von einem zweiten Kanaltyp, der in dem genannten zweiten Verunreinigungsbereich gebildet ist, dadurch gekennzeichnet, daß der dritte Transistor in den genannten Halbleiterkörper gebildet ist, der eine geringere Verunreinigungskonzentration als der genannte erste Verunreinigungsbereich hat, welcher genannte dritte Transistor ein MOS-Transistor vom ersten Kanaltyp ist, der außerhalb der ersten und zweiten Verunreinigungsbereiche gebildet ist und Source- und Drain-Bereiche (45) von dem zweiten Leitfähigkeitstyp hat, und eine höhere Widerstandsspannung als der genannte erste Transistor hat, wobei eine CMOS-Schaltung durch den genannten ersten Transistor und den genannten zweiten Transistor gebildet wird.

2. Halbleitervorrichtung nach Anspruch 1, dadurch gekennzeichnet, daß die ersten und dritten Transistoren p-Kanal-MOS-Transistoren und der genannte zweite Transistor ein n-Kanal-MOS-Transistor sind.

3. Halbleitervorrichtung nach Anspruch 1 oder 2, dadurch gekennzeichnet, daß der genannte dritte Transistor zwischen den genannten ersten und zweiten Transistoren angeordnet ist.

4. Halbleitervorrichtung nach einem der vorhergehenden Ansprüche, dadurch gekennzeichnet, daß der genannte dritte Transistor eine größere Gatebreite als die genannten ersten und zweiten Transistoren hat.

**Revendications**

1. Un dispositif à semiconducteur comprenant un corps semiconducteur (21) d'un premier type de conductivité, une première région d'impureté (28) étant formée dans ledit corps semiconducteur et ayant ledit premier type de conductivité, ladite première région d'impureté ayant une concentration en impureté plus élevée que ledit corps semiconducteur; un premier transistor MOS d'un premier type de canal formé dans ladite première région d'impureté; une deuxième région d'impureté (27) étant formée dans ledit corps semiconducteur et ayant un deuxième type de conductivité opposé audit premier type de conductivité; et un deuxième transistor MOS d'un deuxième type de canal formé dans ladite deuxième région d'impureté, caractérisé en ce qu'un troisième transistor est formé dans ledit corps semiconducteur, possédant une concentration en impureté polus faible due ladite première région d'impureté, ledit troisième transistor étant un transistor MOS du premier type de canal, formé à l'extérieur des première et deuxième régions d'impureté, ayant des régions de source et de drain (45) du deuxième type de conductivité, et ayant une tension admissible plus élevée que ledit premier transistor, un circuit CMOS étant formé par ledit prmier transistor et ledit deuxième transistor.

2. Dispositif à semiconducteur selon la revendication 1, caractérisé en ce que lesdits premier et troisième transistors sont des transistors MOS à canal p et ledit deuxième transistor est un transistor MOS à canal n.

3. Dispositif à semiconducteur selon la revendication 1 ou 2, caractérisé en ce que ledit troisième transistor est placé entre lesdits premier et deuxième transistors.

4. Dispositif à semiconducteur selon l'une quelconque des revendications précédentes, caractérisé en ce que ledit troisième transistor a une largeur de grille plus grande que lesdits premier et deuxième transistors.

# Fig. 1

# Fig. 2A

# Fig. 2B

*Fig. 2C*

B⁺

26

22

n

n⁻

21

*Fig. 2D*

22

p          n          p

27         28    n    27

21

*Fig. 3A*

29

22

21

*Fig. 3B*

P⁺

34

22

29    29    29    21

*Fig. 3C*

B⁺

35

22

n

29    29    29    21

*Fig. 3D*

29    29    29

22

n    p

28    27    21

# Fig. 4